# EUROPEAN PATENT APPLICATION

(11) **EP 0 926 936 A1**
(43) Date of publication of application: **30.06.1999**
(21) Application number: 97830719.7
(22) Date of filing: 24.12.1997
(51) Int. Cl.: H05K 7/00, H05K 7/18, H02B 1/36

(54) **Rack for modules of a computer system with removable support elements**

(71) Applicant: BULL HN INFORMATION SYSTEMS ITALIA S.p.A., 10014 Caluso (Torino) (IT)
(72) Inventor: Mondori, Luciano, 20082 Binasco - Milano (IT); Ramez, Gerard, 49170 Saint George sur Loire (FR)
(74) Representative: Pezzoli, Ennio

(57) **Abstract**

Rack (100) for modules of a computer system comprising a supporting structure (115a, 115b, 120a, 120b) and slideway means (130a, 135a, 130b, 135b) fixed to the supporting structure (115a, 115b, 120a, 120b) for sliding each module (105) in an essentially horizontal direction (143) as the module (105) is inserted into the rack (100) and as the module (105) is removed from the rack (100), and at least one support element (155a, 155b) that can be removably fixed to the supporting structure (115a, 115b, 120a, 120b) for supporting the module (105) as it is inserted or removed.

## Description

The present invention relates to a rack for the modules of a computer system and, specifically, to a rack according to the preamble of the first claim.

Computer systems, such as for example minicomputers, consist of various separate modules which are stacked one above the other in a suitable rack. The rack is provided with horizontal slideways (typically fitted with rolling-contact bearings contained in suitable cages) so as to enable the modules to slide in and out. The modules are rather heavy (about 50 kg each), so that at least two people are needed to move them (to insert or remove them). When a module is to be inserted in the rack it has to be lifted and engaged in the rack slideways; the module is then slid into the rack, while still keeping it raised, until it has been fully inserted. The same operations are carried out in reverse when the module is removed from the rack.

One disadvantage of known racks is that, during insertion of a module, the process of engaging the latter in the slideways is an extremely tricky one since it has to be done while supporting the full weight of the said module. What is more, during the initial stages of insertion and during the final stages of removal, it is very difficult to keep the module raised in a perfectly horizontal position in order to ensure that it slides correctly in the rack slideways. There is a serious risk of damage to the slideways and, in particular, to the cages that contain the rolling-contact bearings, when these are present.

The object of the present invention is to overcome the abovementioned drawbacks. In order to achieve this object, the invention provides a rack for the modules of a computer system as described in the first claim, together with a support element to be used in the said rack.

Further characteristics and the advantages of the rack according to the present invention will become apparent from the description given below of one of its preferred embodiments, which description is given by way of non-limiting example and with reference to the appended figures, in which:
Fig. 1 shows a partial view of an example of a rack according to the present invention;
Figs 2a and 2b show, in detail and at different stages of operation, the support element used in the rack of Fig. 1.

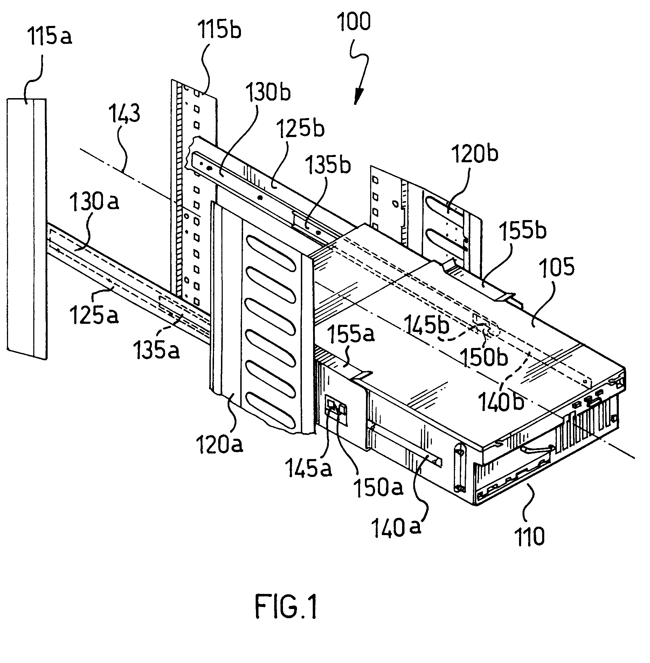

With reference in particular to Fig. 1, the latter illustrates a rack 100 for a computer system, typically a medium or large system, such as for example a minicomputer or a mainframe. The rack 100 houses a plurality of computer system modules (such as for example a central processing unit, a tape or disk memory unit, and the like) stacked one above the other; so as to simplify the description, the figure shows only one module (or drawer) 105 (similar comments apply to the other modules in the computer system). The module 105 is enclosed within a metal box, the rear wall of which is fitted with various connectors 110 that connect the module 105 to the other modules in the computer system and to an external electrical supply source by means of suitable connecting cables (not shown in the figure).

The rack 100 consists of a supporting frame with rear access, comprising two front lateral uprights 115a, 115b and two rear lateral uprights 120a, 120b which are closed off on each side by a removable panel (not shown in the figure). Each front upright 115a, 115b is connected to its corresponding rear upright 120a, 120b by a plurality of crosspieces 125a, 125b (only one of which is shown in the figure for each side). Alternatively, a different number of uprights, fixed side walls or other equivalent supporting structures could be provided.

The internal surface of each crosspiece 125a, 125b carries a fixed telescopic slideway formed by an outer element 130a, 130b which is riveted to the crosspiece 125a, 125b and by an inner element 135a, 135b which slides inside the corresponding outer element 130a, 130b; typically, the outer slideway element 130a, 130b is fitted with rolling-contact bearings (for example ball bearings) which are separated from each other by means of suitable containing cages (not shown in the figure). A corresponding movable slideway 140a, 140b is fixed (for example screwed) to each side wall of the module 105 so as to allow the module 105 to slide in an essentially horizontal direction 143 as it is inserted or removed. The movable slideways 140a, 140b terminate, close to one of their internal ends, in an outwardly projecting sprung portion 145a, 145b; the projecting portion 145a, 145b snap-engages in a corresponding aperture 150a, 150b made close to the free end of the inner slideway element 135a, 135b, thereby forming a safety catch for the module 105. However, the present invention also lends itself to being made with non-telescopic fixed slideways, without bearings, without safety catches or with other equivalent slideway means.

The rack 100 according to the present invention includes one or more support elements that can be removably fixed (as described in detail below) to the supporting structure of the rack 100 so as to keep the module 105 raised as it is inserted or removed. The rack 100 preferably includes two support elements 155a and 155b positioned transversely to the sliding direction 143 so that the module 105 is kept raised in a perfectly balanced manner; however, the present invention also lends itself to being made with a different number of support elements (even with only one) for each module.

When the module 105 is to be inserted in the rack 100, the support elements 155a, 155b are fixed to the rack 100 at the height of the fixed slideways 130a, 135a and 130b, 135b. The module 105 is placed on the support elements 155a, 155b and is pushed inside the rack 100 until the movable slideways 140a, 140b engage in the corresponding fixed slideways 130a, 130b and 130b, 135b. At this point, the module 105 is made to slide in the direction 143 until it is fully inserted in the rack 100, after which the support elements 155a, 155b can be removed.

Similarly, when the module 105 is to be removed from the rack 100, the support elements 155a, 155b are fixed to the rack 100 at the height of the module 105. The module 105 is made to slide in the direction 143 until the projecting portions 145a, 145b engage in the corresponding apertures 150a, 150b, preventing the module from coming out of the rack 100. By pressing the projecting portions 145a, 145b inwards, the movable slideways 140a, 140b are disengaged from the corresponding fixed slideways 130a, 130b and 130b, 135b. At this point, the module 105 can be pulled out of the rack 100 and the support elements 155a, 155b can then be removed.

The structure of the present invention makes it easier to insert and remove the module. In particular, once the module has been placed on the support elements, it is extremely easy to engage the slideways since the module is automatically located in the correct position. Once the module is placed on the support elements, it can be held in position by the operators using only one hand at the back, so that the hand at the front is free to work on the slideways, for example disengaging them when the module is being removed from the rack. Moreover, the support elements keep the module in an essentially horizontal position during the initial stages of the insertion operation and during the final stages of the removal operation; in this way, the fixed slideways and the movable slideways are held in alignment with each other so that there is no risk of damaging the slideways and, in particular, the cages that contain the rolling-contact bearings, when these are present.

The rack according to the present invention takes up no extra space since the support elements can be removed at the end of the module handling operations (insertion or removal). This means that it is possible to use only one pair of support elements which are then attached, as and when required, in various positions on the same or on different racks.

Using the structure of the present invention is particularly advantageous when assembling computer systems in the factory. This solution also makes it possible to replace modules or to carry out maintenance operations on computer systems which have already been installed at a client's premises in an extremely simple manner; all that needs to be done in such cases is to take only the support elements to a client's premises so that they can be used on the racks of the computer systems already installed there.

It should furthermore be noted that the support elements described above lend themselves to being made and sold separately from the rack, so that they can be used with existing racks.

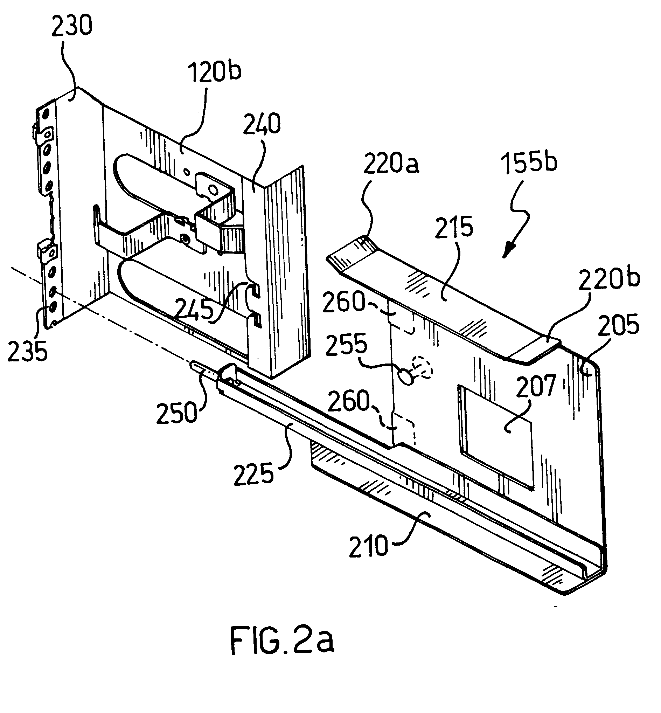

A preferred embodiment of the support elements of the rack described above is illustrated in Fig. 2a (the same reference numerals have been used to identify those elements already illustrated in Fig. 1). The support element 155b (similar comments apply to the other support element) consists of a vertical plate 205 whose length (in the direction of the sliding action) is about 10-30 cm. The plate 205 is made from galvanized sheet metal and is therefore cheap to produce, strong and at the same time sufficiently lightweight; alternatively, other equivalent materials such as aluminium, synthetic fibres and the like can be used. An opening 207 is made in the plate 205 so as to allow access to the safety catch of the slideways.

The bottom of the plate 205 is bent in at right angles so as to form a flange 210 which supports the module of the computer system from beneath. Similarly, the top of the plate 205 is bent in at right angles so as to form an upper flange 215 (which need not be as strong as the lower support flange 210), which is advantageously used to hold the module in vertical alignment. The free internal and external ends of the upper flange 210 are bent slightly upwards so as to form an internal guide tab 220a and an external guide tab 220b, respectively, for guiding the module during its removal and insertion, respectively. A channel-shaped element 225 (which is open at the front and closed at the rear) is fixed, for example welded, to the inside of the lower support flange 210 and to the plate 205; this element advantageously imparts greater rigidity to the structure of the support element 155b and is used to hold the module in horizontal alignment.

The upright 120b includes a flange 230 which extends perpendicularly inwards and contains vertically aligned holes 235, commonly used to secure the module once it has been inserted into the rack. Another flange 240 (set further back relative to the flange 230) also extends inwards and is then bent at right angles towards the front of the rack; notches 245 in the shape of an upturned L (with an outer horizontal portion and an inner vertical portion) are made in the free edge of the flange 240 and are commonly used to hook support bars for the connecting cables (not shown in the figure).

A pin 250 that engages in the holes 235 projects from the internal end of the channel-shaped element 225. Another pin 255, terminating in a disc-shaped head which engages in the notches 245, extends perpendicularly from an outer surface of the plate 205. Two tabs 260, bent outwards and parallel to the plate 205, extend from a free front edge of the latter so as to engage with the free edge of the flange 240.

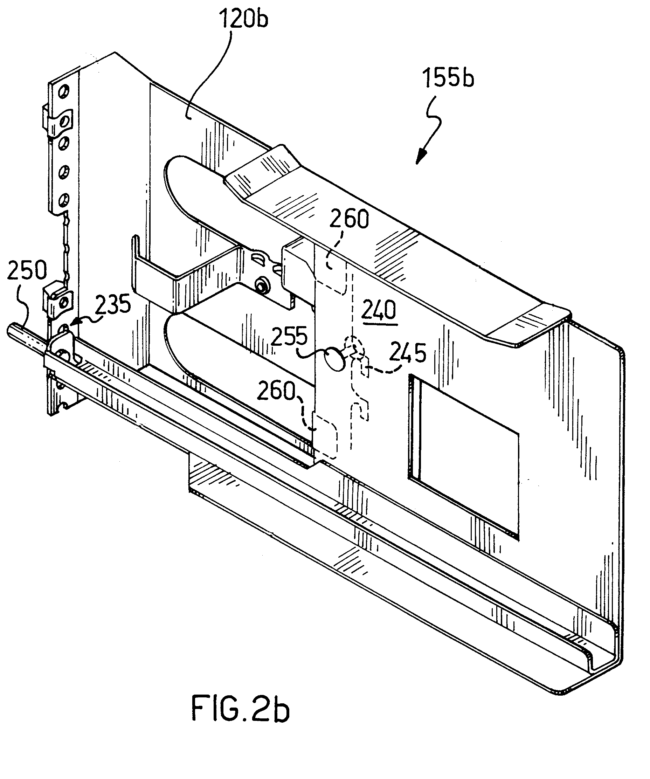

During use, as illustrated in Fig. 2b (the same reference numerals have been used to identify those elements already illustrated in Fig. 2a), the pin 250 is fully inserted in a corresponding hole 235. The support element 155b is then pulled towards the back of the rack so that the pin 255 is inserted in the horizontal portion of a corresponding L-shaped notch 245 and the tabs 260 engage with the free edge of the flange 240. At this point, the support element 155b is pushed downwards until the pin 255 reaches the bottom of the vertical portion of the L-shaped notch 245. The same operations are carried out in reverse to remove the support element 155b from the upright 120b.

The embodiment described above allows the support element 155b to be fixed to the supporting structure of the rack (and to be removed therefrom) easily and quickly; the fixing system thus produced is, nevertheless, extremely rigid and secure. This solution does not require any modifications to be made to the supporting structure of the rack and can, therefore, be applied directly to racks currently in use. What is more, the support element described above is particularly compact, simple, inexpensive and can be mass-produced at low cost. However, the present invention also lends itself to being implemented using different support elements, for example elements having an L-shaped cross-section and only the lower support flange, having a bayonet fastening, and the like.

Needless to say, a person skilled in the art could, in order to satisfy contingent and specific requirements, make numerous modifications and changes to the rack for housing the modules of a computer system as described above, all such modifications and changes moreover remaining within the scope of protection of the invention, as defined by the following claims.

## Claims

1. Rack (100) for modules (105) of a computer system comprising a supporting structure (115a, 115b, 120a, 120b) and slideway means (130a, 135a, 130b, 135b) fixed to the supporting structure (115a, 115b, 120a, 120b) for sliding each module (105) in an essentially horizontal direction (143) as the module (105) is inserted into the rack (100) and as the module (105) is removed from the rack (100),
characterized in that it includes at least one support element (155a, 155b) that can be removably fixed to the supporting structure (115a, 115b, 120a, 120b) for supporting the module (105) as it is inserted or removed.

2. Rack (100) according to Claim 1, comprising a first (155a) and a second (155b) of the said support elements that can be fixed to the rack (100) transversely to the sliding direction (143).

3. Rack (100) according to Claim 1 or 2, in which each support element (155b) includes a plate (205) from which a first flange (210) extends perpendicularly for supporting the module (105) from beneath.

4. Rack (100) according to Claim 3, in which the support element (155b) includes a second flange (215) which extends perpendicularly from the plate (205 )for holding the module (105) in vertical alignment.

5. Rack (100) according to Claim 4, in which the slideway means (130a, 135a, 130b, 135b) are fitted with a safety catch (150a, 150b) for preventing the module (105) from coming out of the rack (100), an opening (207) being made in the plate (205) for accessing the safety catch (150a, 150b).

6. Rack (100) according to Claim 4 or 5, in which each free end of the second flange (215) is bent away from the support element (155b) so as to form a first (220a) and a second (220b) tab for guiding the module (105).

7. Rack (100) according to any one of Claims 3 to 6, in which the support element (155b) includes a stiffening channel-shaped structure (225) fixed to the inside of the first flange (210) and to the plate (205).

8. Rack (100) according to Claim 7, in which the supporting structure (115a, 115b, 120a, 120b) includes a plurality of holes (235) which are mutually aligned parallel with an axis of the supporting structure (115a, 115b, 120a, 120b) and are formed in a third flange (230) positioned perpendicularly to the sliding direction (143), and a plurality of notches in the shape of an upturned L (245) which are mutually aligned parallel with the axis of the supporting structure (115a, 115b, 120a, 120b) and are formed along a free edge of a fourth flange (240) positioned perpendicularly to the third flange (230), the support element (155b) comprising a first pin (250) that extends from the channel-shaped structure (225) for inserting in a corresponding hole (235) and a second pin (255) that extends from the plate (205) for inserting in a corresponding notch (245).

9. Rack (100) according to Claim 8, in which the support element (155b) includes at least one tab (260) that extends parallel with the plate (205) for engaging with the free edge of the fourth flange (240).

10. Support element (155a, 155b) for use in the rack (100) according to any one of Claims 1 to 9.

11. Method for inserting a module (105) of a computer system in a rack (100) or for removing the module (105) from the rack (100), the method comprising the following steps:
fixing at least one support element (155a, 155b) to a supporting structure (115a, 115b, 120a, 120b) of the rack (100) so as to support the module (105) as it is inserted or as it is removed,
sliding the module (105) in an essentially horizontal direction (143) using slideway means (130a, 135a, 130b, 135b) fixed to the supporting structure (115a, 115b, 120a, 120b), the module (105) being supported by the at least one support element (155a, 155b), and
removing the at least one support element (155a, 155b) from the supporting structure (115a, 115b, 120a, 120b).
